(19) Europäisches Patentamt
European Patent Office
Office européen des brevets

(11) **EP 2 530 691 A2**

## EUROPEAN PATENT APPLICATION

(12)

(43) Date of publication:
**05.12.2012 Bulletin 2012/49**

(51) Int Cl.:
***H01G 9/20*** (2006.01)

(21) Application number: **12162663.4**

(22) Date of filing: **30.03.2012**

| | |
|---|---|
| (84) Designated Contracting States:<br>**AL AT BE BG CH CY CZ DE DK EE ES FI FR GB GR HR HU IE IS IT LI LT LU LV MC MK MT NL NO PL PT RO RS SE SI SK SM TR**<br>Designated Extension States:<br>**BA ME**<br><br>(30) Priority: **30.05.2011 KR 20110051661**<br><br>(71) Applicant: **Samsung SDI Co., Ltd.**<br>**Gyeonggi-do (KR)**<br><br>(72) Inventors:<br> • **Shin, Byong-Cheol**<br>**Gyeonggi-do (KR)** | • **Lee, Ji-Won**<br>**Gyeonggi-do (KR)**<br>• **Kim, Chang-Wook**<br>**Gyeonggi-do (KR)**<br>• **Park, Do-Young**<br>**Gyeonggi-do (KR)**<br><br>(74) Representative: **Kurtz, Laurent Charles Edmond**<br>**Santarelli,**<br>**14 avenue de la Grande Armée,**<br>**BP 237**<br>**75822 Paris Cedex 17 (FR)** |

(54) **Method of manufacturing a photoelectrode structure and the resulting photoelectrode structure**

(57) A method of forming a photoelectrode structure includes: disposing a light-scattering layer including a nanowire on a photoanode substrate; and coating the light-scattering layer with an inorganic binder solution to fix the light-scattering layer on the photoanode substrate. Due to the structure of the photoelectrode structure, the adhesive force between the light-scattering layer and the photoanode substrate is enhanced and the photocurrent density is increased.

## FIG. 1

**EP 2 530 691 A2**

**Description**

**BACKGROUND**

**1. Technical Field**

One or more embodiments of the present invention relate to methods of forming a photoelectrode structure.

**2. Description of the Related Art**

In general, a dye-sensitized solar cell consists of a photoelectrode, an opposite electrode, and an electrolyte. The photoelectrode is prepared by adsorbing metal oxide nanoparticles having a wide band gap energy and a photosensitive dye to a transparent substrate. The opposite electrode is prepared by coating a transparent substrate with platinum.

In the dye-sensitized solar cell, the photosensitive dye absorbs solar light incident upon the cell and transitions the light to an excited state, thereby sending electrons to a conduction band of metal oxide. Conducted electrons move toward the photoelectrode and flow into an external circuit to deliver electric energy. The electrons (whose energy state is lowered by an amount corresponding to the delivered electric energy) move toward the opposite electrode. Then, the photosensitive dye is supplied with a number of electrons that is identical to the number of electrons that have moved to the metal oxide from the electrolyte solution, thus, reverting to the original state. In this regard, the electrolyte receives electrons from the opposite electrode due to a redox reaction, and delivers the electrons to the photosensitive dye.

The photoelectrode includes a light-absorbing layer containing metal oxide nanoparticles coated with dye, and a light-scattering layer that sends light that is not absorbed by the light-absorbing layer back to the light-absorbing layer. Since the light-scattering layer additionally scatters unabsorbed light, photoelectric conversion efficiency may be enhanced. However, the light-scattering layer generally contains metal oxide particles having a relatively large particle size of about 200 to about 500 nm, which particles only have light-scattering capability and do not deliver generated photoelectrons to a transparent conductive substrate.

Accordingly, there is a need to develop a system in which photoelectrons (which are generated from the dye when solar light is incident on the cell) smoothly move toward the electrode so as to increase the energy conversion efficiency of the dye-sensitized solar cell.

**SUMMARY**

According to one or more embodiments of the present invention, a method of manufacturing a photoelectrode structure induces light scattering and provides a delivery pathway for generated photoelectrons so as to increase photocurrent density and enhance the adhesive strength of the light-scattering layer to the photoanode substrate.

According to one or more embodiments of the present invention, a method of manufacturing a photoelectrode structure includes: disposing a light-scattering layer comprising a nanowire on a photoanode substrate; and applying an inorganic binder solution to the light-scattering layer to fix the light-scattering layer on the photoanode substrate.

**BRIEF DESCRIPTION OF THE DRAWINGS**

These and/or other aspects will be better understood when considered in conjunction with the accompanying drawings, in which:

FIG. 1 is a schematic cross-sectional view of a photoelectrode structure prepared according to an embodiment of the present invention;

FIGS. 2 and 3 are scanning electron microscopy (SEM) images of a surface of a light-scattering layer of a dye-sensitized solar cell manufactured according to Example 1 taken at different magnifications;

FIG. 4 is a SEM image of a microstructure (a) of $TiO_2$ nanowires of a photoelectrode structure manufactured in Example 4 and a cross-section microstructure (b) of the photoelectrode structure;

FIG. 5 is a SEM image of a microstructure (a) of an interface of $TiO_2$ nanowires and a light-absorbing layer in the photoelectrode structure manufactured in Example 4 and a microstructure (b) of the interface when tilted;

FIG. 6 is a graph comparing the photocurrent and voltage of the dye-sensitized solar cells manufactured according to Example 1 and Comparative Examples 1 and 2; and

FIG. 7 is a graph comparing the incident photon to current efficiencies (IPCE) of the dye-sensitized solar cells manufactured according to Example 1 and Comparative Examples 1 and 2.

## DETAILED DESCRIPTION OF THE INVENTION

Throughout the following description and accompanying drawings, like reference numerals refer to like elements. Also, although the present invention is described with reference to certain exemplary embodiments with reference to the accompanying drawings, the present invention is not limited to the specific embodiments described and illustrated herein.

According to embodiments of the present invention, a method of manufacturing a photoelectrode structure includes disposing a light-scattering layer including a nanowire on a photoanode substrate; and applying an inorganic binder solution to the light-scattering layer to fix the light-scattering layer on the photoanode substrate.

According to embodiments of the present invention, the photoanode substrate may include a light-transmissible conductive substrate, and a light-absorbing layer disposed on the light-transmissible conductive substrate, where the light-absorbing layer includes nanoparticles to which dye is absorbed.

The light-transmissible conductive substrate may be, for example, a transparent substrate coated with a conductive film. Nonlimiting examples of the material for forming the conductive film may be indium tin oxide (ITO), fluorine doped tin oxide (FTO), antimony doped tin oxide (ATO), indium zinc oxide (IZO), aluminium doped zinc oxide (AZO), gallium doped zinc oxide (GZO), $SnO_2$, $In_2O_3$, ZnO, and conductive impurity-doped $TiO_2$. For example, the material for forming the conductive film may be any one of various transparent conductive oxides that are used in the art. The conductive film may be formed by depositing at least one of these oxides, or a combination of oxides.

The transparent substrate that supports the conductive film of the light-transmissible conductive substrate may be transparent so as to allow external light to enter, and may be a transparent inorganic substrate formed of quartz or glass, or a plastic substrate. If a flexible dye-sensitized solar cell is desired, a plastic substrate may be suitable. Nonlimiting examples of a plastic material for the substrate include polyethylene terephthalate (PET), polyethylene naphthalate (PEN), polycarbonate (PC), polypropylene (PP), polyimide (PI), triacetyl cellulose (TAC), and polystyrene.

The light-absorbing layer disposed on the light-transmissible conductive substrate may include nanoparticles to which dye is absorbed. An average particle size of the nanoparticles may be about 5 to about 50 nm. In some embodiments, for example, the average particle size of the nanoparticles may be about 5 to about 20 nm. In other embodiments, the average particle size of the nanoparticles may be about 10 to about 50 nm. If the average particle size of nanoparticles is within these ranges, the specific surface area of the nanoparticles is sufficiently large, enabling better adsorption of the dye molecules, yielding a stronger intensity of absorbed light.

The nanoparticles may be a semiconductor material having a lower conduction band energy than the lowest unoccupied molecular orbital (LUMO) of the dye. The nanoparticles may include at least one semiconductor material selected from titanium (Ti) oxide, tin (Sn) oxide, niobium (Nb) oxide, zirconium (Zr) oxide, tungsten (W) oxide, vanadium (V) oxide, zinc (Zn) oxide, copper (Cu) oxide, iron (Fe) oxide, lead (Pb) oxide, bismuth (Bi) oxide, cadmium (Cd) oxide, tantalum (Ta) oxide, strontium (Sr) oxide, indium (In) oxide, iridium (Ir) oxide, lanthanum (La) oxide, molybdenum (Mo) oxide, magnesium (Mg) oxide, aluminum (Al) oxide, yttrium (Y) oxide, scandium (Sc) oxide, samarium (Sm) oxide, gallium (Ga) oxide, strontium titanium (SrTi) oxide, potassium tantalum (KTa) oxide, barium titanium (BaTi) oxide, iron titanium (FeTi) oxide, yttrium iron (YFe) oxide, cadmium iron (CdFe) oxide, lead iron (PbFe) oxide, mercury niobium (HgNb) oxide, ZnS, $In_2S_3$, CdS, $ZrS_2$, HgS, $MoS_2$, $HfS_2$, $Fe_2S$, and PbS. For example, the nanoparticles may include titanium dioxide ($TiO_2$), zinc oxide (ZnO), tin dioxide ($SnO_2$), niobium oxide ($Nb_2O_5$) tungsten trioxide ($WO_3$), or a mixture thereof. In some embodiments, for example, the nanoparticles may include titanium dioxide ($TiO_2$), which has good photoelectron generation efficiency. However, the nanoparticles are not limited to the above list and may be any one of various semiconductor materials that are used in the art.

The nanoparticles may be porous so as to widen the surface area to which the dye is adsorbed, thereby enhancing the electron generation efficiency of the dye that generates the photoelectrons.

The dye that is adsorbed to the nanoparticles is a material that is directly engaged in generating photoelectrons. The dye may be a dye that absorbs light in the visible spectrum and has a high absorption coefficient. The LUMO of the dye is higher than the conduction band energy of the semiconductor material of the nanoparticles. Nonlimiting examples of suitable dyes for use in forming the photoelectrode structure include organometallic compounds, organic compounds, and quantum dot inorganic compounds, such as InP, or CdSe. Nonlimiting examples of the organometallic compound include compounds including metals, such as aluminum (Al), platinum (Pt), palladium (Pd), europium (Eu), lead (Pb), iridium (Ir), or ruthenium (Ru). For example, the dye may be ruthenium-based N3, N719, or black dye, but is not limited thereto, and the dye may be any one of various dyes that are sensitive to solar light and used in the art. As used herein, N3 represents $RuL_2 (NCS)_2$ (where L=2,2'-bipyridyl-4,4'-dicarboxylic acid), and N719 represents $RuL_2(NCS)_2$: 2 TBA (where L=2,2'-bipyridyl-4,4'-dicarboxylic acid, TBA=tetra-n-butylammonium).

The thickness of the light-absorbing layer may be equal to or less than about 20 $\mu$m. In some embodiments, for example, the thickness of the light-absorbing layer is about 1 to about 20 $\mu$m. In other embodiments, the thickness of the light-absorbing layer is about 1 to about 15 $\mu$m. The light-absorbing layer has high serial resistance due to its structure. Since the increase in serial resistance leads to a decrease in conversion efficiency, controlling the thickness of the light-absorbing layer within the ranges described above sustains the function of the light-absorbing layer while maintaining the serial resistance at low levels, thereby preventing decreases in conversion efficiency.

The photoanode substrate may be prepared using any method that is known in the art. For example, the photoanode substrate may be prepared by applying a paste composition including nanoparticles (for example, titanium dioxide nanoparticles), a binder, and a solvent to a light-transmissible conductive substrate by spin coating, dip coating, or the like to the desired thickness and then heat treating the resultant structure. Further, according to an embodiment of the present invention, an adhesive force between the light-scattering layer and the photoanode substrate may be increased by simultaneously heat treating the nanoparticles that are applied to form the light-absorbing layer and the nanowires that are deposited thereon to form the light-scattering layer, so that at least a portion of the nanowires present at the interface with the light-absorbing layer is embedded in the light-absorbing layer. In this regard, to further enhance the adhesive force of the light-scattering layer, thermal compression or a steaming treatment using an adhesive material such as tetrahydrofurane (THF) may be performed before heat treatment of the deposited nanowires.

According to other embodiments of the present invention, the photoanode substrate may be a light-transmissible conductive substrate on which a light-absorbing layer is not disposed. If a separate light-absorbing layer is not disposed on the light-transmissible conductive substrate as described above, the dye may be adsorbed to the light-scattering layer. Alternatively, nanoparticles (which are used in the light-absorbing layer), may be further included in the light-scattering layer and dye is adsorbed to the nanoparticles, so as to provide a light absorbing function and a photoelectron generation function to the light-scattering layer.

Once the photoanode substrate is prepared, a light-scattering layer including a nanowire is disposed on the photoanode substrate.

The nanowire included in the light-scattering layer may have conductivity and a one-dimensional linear structure. To obtain a light scattering effect, the diameter of the nanowire may be controlled to about 100 to about 600 nm, for example, about 200 to about 500 nm.

The nanowire may include at least one semiconductor material selected from titanium (Ti) oxide, tin (Sn) oxide, niobium (Nb) oxide, zirconium (Zr) oxide, tungsten (W) oxide, vanadium (V) oxide, zinc (Zn) oxide, copper (Cu) oxide, iron (Fe) oxide, lead (Pb) oxide, bismuth (Bi) oxide, cadmium (Cd) oxide, tantalum (Ta) oxide, strontium (Sr) oxide, indium (In) oxide, iridium (Ir) oxide, lanthanum (La) oxide, molybdenum (Mo) oxide, magnesium (Mg) oxide, aluminum (Al) oxide, yttrium (Y) oxide, scandium (Sc) oxide, samarium (Sm) oxide, gallium (Ga) oxide, strontium titanium (SrTi) oxide, potassium tantalum (KTa) oxide, barium titanium (BaTi) oxide, iron titanium (FeTi) oxide, yttrium iron (YFe)oxide, cadmium iron (CdFe) oxide, lead iron (PbFe) oxide, mercury niobium (HgNb) oxide, $ZnS$, $In_2S_3$, $CdS$, $ZrS_2$, $HgS$, $MoS_2$, $HfS_2$, $Fe_2S$, and $PbS$. For example, the nanowire may be a titanium dioxide ($TiO_2$) nanowire, a zinc oxide (ZnO) nanowire, or a mixture thereof. However, the nanowire is not limited to these materials, and may include any one of various semiconductor materials that have light-scattering effect and conductivity and that are used in the art. The nanowire and the nanoparticles may be formed using identical or different semiconductor materials.

The nanowire may be formed in various ways, for example, chemical vapor deposition (CVD), laser ablation, thermal evaporation, electrodeposition, or electrospinning, etc. According to some embodiments, the nanowire may be formed by electrospinning. Due to the electrospinning, the light-scattering layer may have a structure in which the nanowire is tangled.

For example, disposing the light-scattering layer may include electrospinning a precursor solution including a nanowire precursor on a surface of the photoanode substrate and then heat treating the precursor solution.

For example, the precursor solution may be prepared by adding a nanowire precursor to a solvent, and if necessary, the solution may further include a binder, an acid for controlling pH, or other additives.

The nanowire precursor may include, for example, at least one selected from titanium isopropoxide, titanium ethoxide, titanium chloride, and titanium methoxide. If a titanium compound is used as the nanowire precursor as described above, a light-scattering layer including a titanium dioxide nanowire may be formed. However, the nanowire precursor is not limited thereto and may be any one of various precursors that form titanium dioxide by heat treatment.

In the precursor solution, the amount of the nanowire precursor may be about 5 to about 30 weight (wt.)% based on a total weight of the nanowire precursor and the solvent. In some embodiments, for example, the amount of the nanowire precursor may be about 10 to about 20 wt.% based on the total weight of the nanowire precursor and the solvent. If the amount of the nanowire precursor is within these ranges, the nanowire precursor may be uniformly dispersed in the precursor solution and thus a uniform nanowire may be formed.

Nonlimiting examples of the solvent for dissolving the nanowire precursor including terpineol, ethanol, distilled water, ethylene glycol, alpha-terpineol and the like. For example, the solvent may be any solvent that is used in the art.

An amount of the solvent may be about 70 to about 95 wt.% based on the total weight of the nanowire precursor and the solvent. In some embodiments, for example, the amount of the solvent may be about 80 to about 90 wt.% based on the total weight of the nanowire precursor and the solvent. If the amount of the solvent is within these ranges, the nanowire precursor may be uniformly dispersed in the precursor solution.

The precursor solution may further include a binder for binding the nanowire (which is formed by electrospinning the precursor solution) to the photoanode substrate with a desired level of adhesive strength. Nonlimiting examples of the binder include polyvinyl pyrrolidone (PVP), ethyl cellulose, and hydroxypropyl cellulose. For example, the binder may be any one of various binders that are used in the art and that are thermally decomposed at a temperature of 400°C or higher.

An amount of the binder in the precursor solution may be about 10 to about 40 parts by weight based on 100 parts by weight of the nanowire precursor. In some embodiments, for example, the amount of the binder in the precursor solution may be about 20 to about 30 parts by weight based on 100 parts by weight of the nanowire precursor. If the amount of the binder is within these ranges, the precursor solution may retain an appropriate viscosity and thus, electrospinning may be easily performed, and the formed nanowires may have an appropriate binding force.

Also, the precursor solution may further include an acid for controlling the degree of acidity (pH). For example, the precursor solution may include an acetic acid. Also, if desired, the precursor solution may further include other additives.

Once the precursor solution is prepared, the precursor solution is electrospun on a surface of the photoanode substrate and then heat treated to form a light-scattering layer.

According to embodiments of the present invention, the precursor solution may be electrospun to form the light-scattering layer such that the light-scattering layer covers at least a portion of the light-absorbing layer disposed on the light-transmissible conductive substrate, and such that at least a portion of the light-scattering layer contacts the light-transmissible conductive substrate. Since the light-scattering layer including a nanowire contacts the light-transmissible conductive substrate, the light-scattering layer may induce light scattering and may also provide a delivery pathway for transporting photoelectrons generated by the light-absorbing layer to the light-transmissible conductive substrate through the nanowire of the light-scattering layer. By doing so, the number of interfaces through which photoelectrons pass is relatively decreased. Accordingly, losses of photoelectrons due to their recombination may be reduced, and photocurrent density may be increased, thus increasing photoelectric conversion efficiency.

The electrospinning may be performed, for example, at a speed of about 10 to about 20 $\mu$l/min for about 10 to about 30 minutes with the precursor solution at a voltage of about 5 to about 10 kV. Under these electrospinning conditions, the thickness of the light-scattering layer may be controlled according to the electrospinning time.

Also, when the precursor solution is electrospun, for example, a hot plate may be used to maintain the temperature of the photoanode substrate at about 100 to about 350°C. As described above, if electrospinning is performed on the photoanode substrate while the temperature of the photoanode substrate is higher than room temperature, the adhesive strength of the electrospun nanowire may be increased.

After the nanowire precursor solution is electrospun, heat treatment of the resultant structure may be performed at a temperature of about 400 to about 600°C. For example, the heat treatment temperature may be about 400 to about 550°C, and in some embodiments, for example, about 400 to about 500°C. If the heat treatment temperature is too high, the photoanode substrate may be bent. On the other hand, if the heat treatment temperature is too low, it is difficult to calcinate titanium dioxide. Accordingly, if the heat treatment temperature is within the ranges described above, the light-scattering layer may have fewer defects and high photoconductive efficiency.

A thickness of the light-scattering layer may be about 0.1 to about 10 $\mu$m. In some embodiments, for example, the thickness of the light-scattering layer may be about 0.5 to about 3 $\mu$m. If the thickness of the light-scattering layer is within these ranges, the light-scattering layer may have high photoconductivity efficiency and good light-scattering effect.

After the light-scattering layer is disposed, the dye may be adsorbed to the light-scattering layer. If the dye is adsorbed to the nanowire of the light-scattering layer, the light-scattering layer may absorb solar light and generate photoelectrons, thereby performing (in addition to its original light scattering function) a function of generating and transporting photoelectrons. The dye used herein may be identical to the dye that is described above for the light-absorbing layer. Also, selectively, adsorbing the dye to the light-scattering layer may be performed after the light-scattering layer is fixed on the photoanode substrate by coating with an inorganic binder solution.

After the light-scattering layer is disposed on the photoanode substrate, the inorganic binder solution is disposed on the light-scattering layer to fix the light-scattering layer on the photoanode substrate.

Although the nanowire of the light-scattering layer (obtained by heat treating the nanowire precursor solution after electrospinning) may have a certain level of adhesive strength, the adhesive strength of the nanowire may not be sufficiently strong to completely fix the light-scattering layer on the photoanode substrate. Accordingly, by coating the light-scattering layer with the inorganic binder solution, the adhesive strength may be enhanced and the light-scattering layer may be fixed on the photoanode substrate.

Applying the inorganic binder solution may be performed by at least one of spin coating, dip coating, roll coating, screen coating, spray coating, and screen printing.

Also, the method may further include, after applying the inorganic binder solution, heat treating the light-scattering layer coated with the inorganic binder solution. For example, the light-scattering layer coated with the inorganic binder solution may be heat treated at a temperature of about 250 to about 500°C. Through the heat treatment, the solvent or binder included in the inorganic binder solution may thermally decompose, and the inorganic material included in the inorganic binder solution may be attached to a surface of the nanowire, or coated on a surface of the nanowire, thereby fixing the light-scattering layer on the photoanode substrate with enhanced adhesive force between nanowires.

The coating and heat treatment of the inorganic binder solution may be repeatedly performed as needed.

According to some embodiments, the inorganic binder solution may be a $TiO_2$ sol. The $TiO_2$ sol may include $TiO_2$ nanoparticles having a particle diameter of about 5 to about 50 nm. For example, the $TiO_2$ sol may be a sol in which $TiO_2$ nanoparticles are dispersed in a binder (such as ethylcellulose, hydroxypropylcellulose, etc.) by using a phosphate ester-based surfactant or a polar acidic ester of a long chain alcohol-based additive as a dispersing agent for dispersing the $TiO_2$ nanoparticles. When a $TiO_2$ sol is used, the $TiO_2$ nanoparticles remain attached to the nanowire through heat treatment after application, and improve the adhesive strength between nanowires. In this case, the $TiO_2$ nanoparticles attached to the surface of the nanowire provide a light absorbance function or a light scattering function.

According to some embodiments, the inorganic binder solution may be an $NbCl_5$-containing solution. For example, the $NbCl_5$-containing solution may include about 10 to about 40 mM of $NbCl_5$. The $NbCl_5$-containing solution may include a solvent such as ethanol, distilled water, ethylene glycol, terpineol, alpha-terpineol, or the like. The $NbCl_5$-containing solution may further include other additives as desired. When the $NbCl_5$-containing solution is applied and the heat treatment performed, the solvent is removed and $NbCl_5$ is converted into an $Nb_2O_5$ oxide which remains coated on the surface of the nanowire. As described above, the $Nb_2O_5$ oxide coated on the surface of the nanowire may enhance the binding force of the nanowire and prevent the recombination of photoelectrons that may occur in the light-scattering layer, thereby improving photocurrent density.

According to an embodiment of the present invention, a photoelectrode structure includes: a photoanode substrate; and a light-scattering layer disposed on the photoanode substrate and including a nanowire, wherein the light-scattering layer is fixed on the photoanode substrate by an inorganic binder.

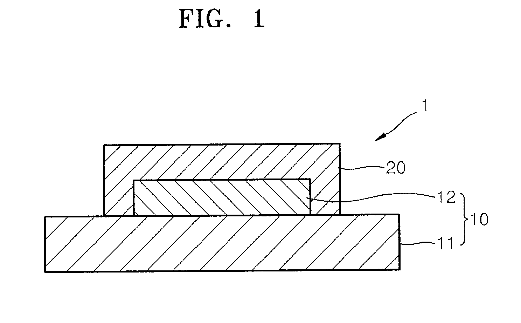

FIG. 1 is a schematic cross-sectional view of a photoelectrode structure 1 prepared according to an embodiment of the present invention. Referring to FIG. 1, the photoelectrode structure 1 includes a photoanode substrate 10 and a light-scattering layer 20, and the photoanode substrate 10 may include a light-transmissible conductive substrate 11 and a light-absorbing layer 12 that is disposed on the light-transmissible conductive substrate 11 and that includes nanoparticles to which a dye is adsorbed.

The light-scattering layer 20 may be formed as a nanowire tangled structure by electro-spinning. The light-scattering layer 20 may be disposed such that the light-scattering layer 20 covers at least a portion of the light-absorbing layer 12 and at least a portion of the light-scattering layer 20 contacts the light-transmissible conductive substrate 11. By doing this, electrons formed in the light-absorbing layer 12 may be easily delivered to the light-transmissible conductive substrate 11.

In the photoelectrode structure 1, photoelectrons move through the nanoparticle interfaces of the light-absorbing layer 12 to the light-transmissible conductive substrate 11, and also move through the nanowire of the light-scattering layer 20 to the light-transmissible conductive substrate 11. Due to the additional pathway for delivering photoelectrons, the number of interfaces through which photoelectrons pass may be relatively reduced, the loss caused by recombination of photoelectrons may be reduced, and photocurrent density may be increased.

The light-scattering layer 20 may be fixed on the photoanode substrate 10 by an inorganic binder. For example, an organic binder solution may be applied on the light-scattering layer 20, followed by heat treating, thereby fixing the light-scattering layer 20 on the photoanode substrate 10. According to an embodiment of the present invention, the inorganic binder solution may be $TiO_2$ sol, and the $TiO_2$ sol may include $TiO_2$ nanoparticles. When the $TiO_2$ sol is used, $TiO_2$ nanoparticles of the inorganic binder solution may remain as being attached to the nanowire through the heat treatment so that a binding force of the nanowire may be increased. In this case, the $TiO_2$ nanoparticles of the inorganic binder attached to the nanowire surface may function as light absorption and light scattering simultaneously. A particle diameter of the $TiO_2$ nanoparticles may be in a range of about 5 to about 50 nm.

According to an embodiment of the present invention, the inorganic binder solution may be an $NbCl_5$-containing solution. For example, the $NbCl_5$-containing solution may include about 10 to about 40 mM concentration of $NbCl_5$. Through applying and then heat treating of the $NbCl_5$-containing solution, a solvent may be removed and $NbCl_5$ is changed into $Nb_2O_5$ oxide, thereby remaining coated on the surface of the nanowire. As described above, the $Nb_2O_5$ oxide coated on the surface of the nanowire may increase a binding force of the nanowire and may also prevent recombination of photo electrons that may occur in the light-scattering layer 20 to increase a photocurrent density.

According to an embodiment of the present invention, in order to increase the adhesive force between the light-scattering layer 20 and the photoelectrode structure 10, at least a portion of the nanowire of the light-scattering layer 20 present at the interface with the light-absorbing layer 12 may be embedded in the light-absorbing layer 12.

A dye-sensitized solar cell including a photoelectrode structure prepared as described above may have enhanced photoelectric conversion efficiency.

A dye-sensitized solar cell according to embodiments of the present invention includes the photoelectrode structure described above; a second electrode facing the light-transmissible conductive substrate (the light-transmissible conductive substrate is hereinafter referred to as the 'first electrode'); and an electrolyte between the light-transmissible conductive substrate (that is, the first electrode) and the second electrode.

The photoelectrode structure is the same as described above. The second electrode may face the first electrode of the photoelectrode structure, and the electrolyte may be disposed between the first electrode of the photoelectrode structure and the second electrode. The second electrode and the electrolyte may have conventional structures, and may be manufactured using conventional manufacturing processes.

For example, a material for forming the second electrode may be any conductive material. However, when the second electrode is formed of an insulating material, a conductive layer may be formed on a side of the second electrode facing the first electrode. For example, the second electrode may include: a transparent substrate; and a transparent electrode including a transparent conductive oxide and a catalyst for activating a redox couple, which are disposed on the transparent substrate.

The transparent substrate used in the second electrode may support the transparent electrode and the catalyst, and may be a transparent inorganic substrate formed of, for example, quartz or glass, or may be a plastic substrate.

The transparent electrode may include a transparent conductive oxide, and as described above with respect to the first electrode (that is, the light-transmissible conductive substrate), the transparent conductive oxide may be any one of various transparent conductive oxides that are used in the art. Nonlimiting examples of the transparent conductive oxide include indium tin oxide (ITO), fluorine doped tin oxide (FTO), antimony doped tin oxide (ATO), indium zinc oxide (IZO), aluminium doped zinc oxide (AZO), gallium doped zinc oxide (GZO), $SnO_2$, $In_2O_3$, ZnO, and conductive impurity-doped $TiO_2$. The transparent electrode may be formed by depositing at least one of these oxides, or a combination of the oxides.

The catalyst activates a redox couple, and may include platinum, gold, silver, ruthenium, palladium, iridium, rhodium (Rh), osmium (Os), carbon (C), $WO_3$, $TiO_2$, or a conductive material, such as a conductive polymer.

The electrolyte may be disposed between the first electrode and the second electrode, and receives electrons from the second electrode due to a redox reaction and delivers the electrons to the dye.

The electrolyte may include a redox couple, such as $I^-/I_3^-$. The source for the $I^-$ ion may be LiI, NaI, alkylammonium iodine or imidazolium iodine, and the $I_3^-$ ion may be generated by dissolving $I_2$ in a solvent. The medium for the electrolyte may be a liquid such as acetonitrile or a polymer such as polyethyleneoxide. Nonlimiting examples of a liquid medium include carbonates, nitrile compounds, and alcohols. For example, the liquid medium may be propylene carbonate, acetonitrile, or methoxy acetonitrile. Nonlimiting examples of a polymer medium include polyacrylonitriles (PAN), acrylionic liquid combinations, pyridines, and polyethyleneoxides (PEO). Also, a gelator may be added to the liquid electrolyte to prepare a gel-type electrolyte.

The following examples are presented for illustrative purposes only and are not intended to limit the scope of the present invention.

Example 1

A titanium dioxide nanoparticle paste (PST 18NR, manufactured by JGC C&C Company) was sequentially coated, dried, coated, and dried on a conductive thin film formed of FTO (2.8T, T: Glass thickness) as a light-transmissible conductive substrate (first electrode). The formed titanium dioxide film was heat treated at a temperature of 500°C for about 30 minutes, and then sequentially coated, dried, coated, dried, and heat treated, thereby forming a light-absorbing layer having a thickness of 10 $\mu$m.

Separately, 1.5 g of titanium isopropoxide, 0.604 ml (0.634 g) of acetic acid, and 3 ml (2.367 g) of ethanol were mixed to prepare a mixture. A mixed solution including 7.5 ml (5.918 g) of ethanol and 0.45 g of polyvinylpyrrolidone (PVP) was added to the mixture to prepare a titanium dioxide nanowire precursor solution. The titanium dioxide nanowire precursor solution was electrospun on the light-absorbing layer at a voltage of 10 kV at a rate of 15 $\mu$l/min for 30 minutes. The spray nozzle used had an inner diameter of 1 mm, and a distance between the spray nozzle and the light-absorbing layer was 30 cm. Also, during the electrospinning, the first electrode on which the light-absorbing layer was disposed was maintained at a temperature of 300°C using a hot plate. After the electrospinning, the resultant structure was heat treated at a temperature of 500°C for 30 minutes, thereby forming a light-scattering layer having a thickness of 2 $\mu$m.

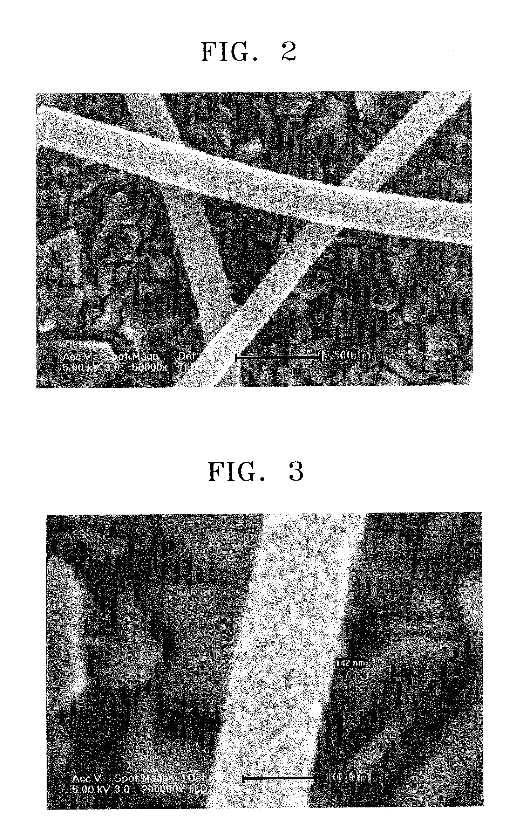

FIGs. 2 and 3 are scanning electron microscopy (SEM) images of the surface of the light-scattering layer of the dye-sensitized solar cell manufactured according to Example 1. Referring to FIGs. 2 and 3, the titanium dioxide nanowires are tangled on the titanium dioxide light-absorbing layer, and an average diameter of each formed nanowire is about 100 to about 140 $\mu$m.

Subsequently, the resultant structure was maintained at a temperature of 80°C and then immersed in a dye dispersion solution in which N719 as the dye was dissolved at a concentration of 0.3 mM in ethanol, and a dye adsorption treatment was performed thereon for 24 hours. Then, the dye-adsorbed light-absorbing layer was washed with ethanol and dried at room temperature.

Then, a 0.1 M solution of $NbCl_5$ 0.1 M solution in ethanol (as a solvent) was spin coated on the dye-adsorbed light-absorbing layer at a rate of 1000 rpm for 10 seconds, and heat treated at a temperature of about 300°C for about 30 minutes, thereby completing the manufacture of a photoelectrode structure.

Separately, a Pt layer was deposited on a fluorine-doped tin oxide transparent conductor as an opposite electrode by sputtering, and then a micropore was formed therein for electrolyte injection using a drill having a diameter of 0.6 mm.

A thermoplastic polymer film having a thickness of 60 $\mu$m was disposed between the photoelectrode structure and the opposite electrode and compressed at a temperature of 90°C for 10 seconds, thereby combining the two electrodes. A redox electrolyte was injected through the micro pore formed in the opposite electrode, and then the micro pore was sealed using a cover glass and a thermoplastic polymer film, thereby completing the manufacture of a dye-sensitized solar cell. The redox electrolyte was prepared by dissolving 0.62 M 1-butyl-3-methylimidazolium iodide, 0.1 M LiI, 0.5 M $I_2$, and 0.5M 4-tert-butylpyridine in an acetonitrile.

Example 2

A dye-sensitized solar cell was manufactured as in Example 1, except that the temperature of the hot plate was maintained at 200°C during electrospinning when forming the light-scattering layer.

Example 3

A dye-sensitized solar cell was manufactured as in Example 1, except that the temperature of the hot plate was maintained at 100°C during electrospinning when forming the light-scattering layer.

The dye-sensitized solar cells manufactured according to Examples 1 to 3 in which the temperature of the hot plate was respectively maintained at 300°C (Example 1), 200°C (Example 2) and 100°C (Example 3) when the nanowire precursor solution was electrospun were compared to each other. As a result, it was confirmed that the higher the temperature of the hot plate, the stronger the cohesive force of the formed light-scattering layer.

Example 4

A dye-sensitized solar cell was manufactured as in Example 1, except that the $TiO_2$ nanoparticle paste coated and dried on the FTO glass was not heat treated and the $TiO_2$ nanoparticle paste and subsequently electro-spun $TiO_2$ nanowire were simultaneously calcined at the temperature of 500°C for about 30 minutes.

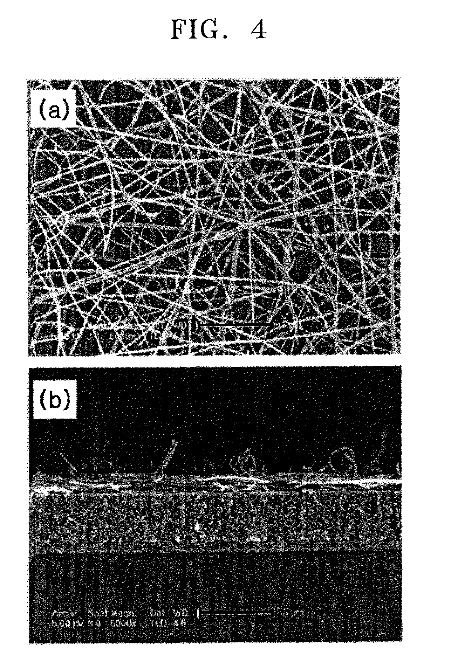

FIG. 4 is a SEM image of a microstructure (a) of a $TiO_2$ nanowire surface of the photoelectrode structure manufactured according to Example 4 and a cross-section microstructure (b) of the photoanode substrate. The image shown in FIG. 4 is an image enlarged at a magnification of 5,000 and a unit length in this case was 5 $\mu$m.

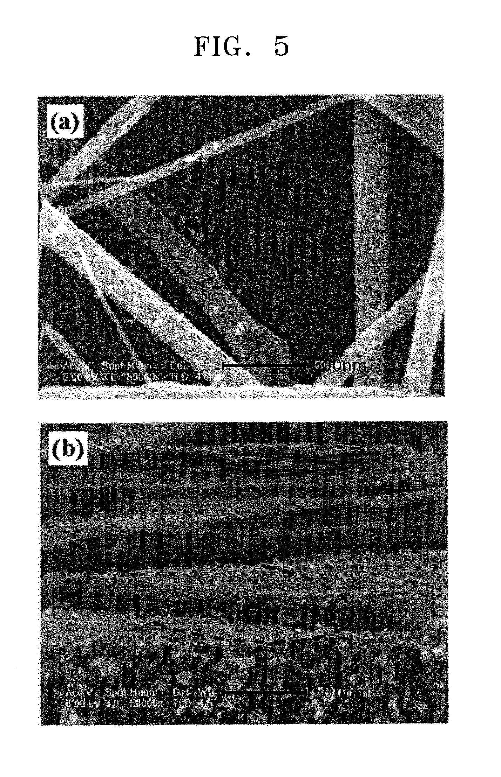

Also, FIG. 5 is a SEM image of a microstructure (a) of an interface of the $TiO_2$ nanowire and the light-absorbing layer and a microstructure (b) of the interface when tilted, which is observed at a magnification of 5,000. Referring to FIG. 5, it was confirmed that the $TiO_2$ nanowire was embedded in the nanoparticles layer (light-absorbing layer) by simultaneous calcination and sintering.

**Comparative Example 1**

A dye-sensitized solar cell was manufactured as in Example 1, except that a photoelectrode structure was used in which only a light-absorbing layer was formed on the light-transmissible conductive substrate (first electrode) without formation of the light-scattering layer.

**Comparative Example 2**

A dye-sensitized solar cell was manufactured as in Example 1, except that a photoelectrode structure was used in which dye was adsorbed to the light-scattering layer and the dye-adsorbed light-scattering layer was not treated with an $NbCl_5$ 0.1 M solution.

**Evaluation Example 1 : Photoconversion Efficiency**

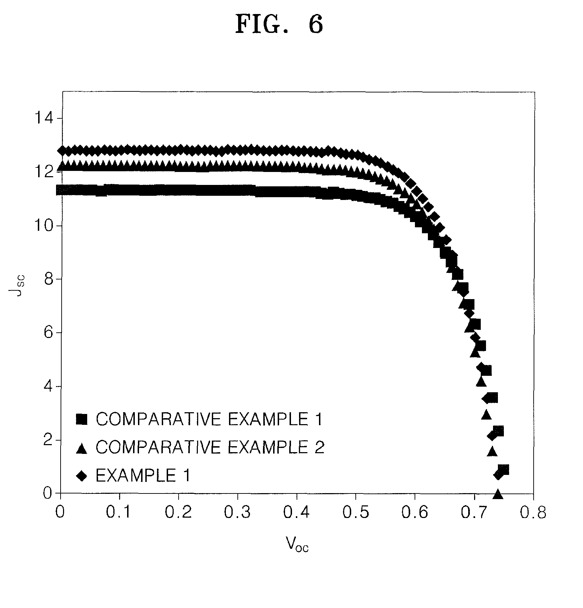

The photocurrent voltage of each of the dye-sensitized solar cells manufactured according to Example 1 and Comparative Examples 1 and 2 was measured and the results are shown in FIG. 6. Also, the open circuit voltage, current density, and fill factor were calculated from the measured photocurrent voltage curve, and the efficiency of the solar cells was evaluated, and the results are shown in Table 1 below.

In this experiment, a xenon lamp was used as a light source, the solar conditions of the xenon lamp were adjusted using a standard solar cell (Fraunhofer Institute Solare Engeriessysysteme, Certificate No. C-ISE369, Type of material: Mono-Si+KG filter), and the power density used was 100 mW/cm$^2$.

The measurement conditions with respect to the open circuit voltage, photocurrent density, energy conversion efficiency, and fill factor shown in Table 1 below are as follows:

(1) open circuit voltage (V) and photocurrent density(mA/cm$^2$): the open circuit voltage and photocurrent density were measured by using Keithley SMU240.

(2) energy conversion efficiency (%) and fill factor (%): the energy conversion efficiency was measured using a 1.5 AM 100 mW/cm$^2$ solar simulator (Xe lamp [300W, Oriel], AM1.5 filter, and Keithley SMU2400), and the fill factor was calculated using the energy conversion efficiency and the following equation.

## Equation

$$fillfactor(\%) = \frac{(J \times V)_{max}}{J_{sc} \times V_{oc}} \times 100$$

In the equation above, J is the value of the Y axis of the energy conversion efficiency curve, V is the value of the X axis of the energy conversion efficiency curve, and Jsc and Voc are respectively the intercept values of the respective axes.

Also, the values were measured twice to take measurement error into consideration, and the results are shown in Table 1 below.

**Table 1**

|  | Current density (Jsc) [mAcm$^{-2}$] | Open circuit voltage (Voc) [V] | Fill factor (FF) [%] | Efficiency η [%] |
|---|---|---|---|---|
| Example1 | 12.80 | 0.74 | 72 | 6.9 |
|  | 12.43 | 0.75 | 71 | 6.6 |
| Comparative Example 1 | 12.04 | 0.74 | 68 | 6.0 |
|  | 11.33 | 0.76 | 73 | 6.2 |
| Comparative Example 2 | 12.22 | 0.74 | 72 | 6.5 |
|  | 12.25 | 0.74 | 72 | 6.5 |

Referring to FIG. 6, it can be confirmed that the dye-sensitized solar cell of Example 1 has higher photocurrent density than the dye-sensitized solar cells of Comparative Examples 1 and 2. The increase in the photocurrent density may result from a decrease in solar light loss. This result may also be confirmed in Table 1. As shown in Table 1, the dye-sensitized solar cell of Example 1 has higher efficiency than the dye-sensitized solar cells of Comparative Examples 1 and 2.

**Evaluation Example 2 : Scattering Effect Evaluation**

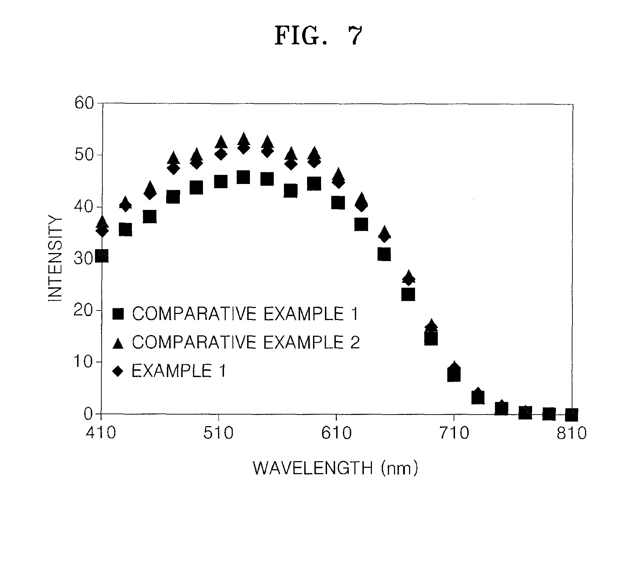

Incident photon-to-current efficiencies (IPCE) of adsorption intensity with respect to a dye absorption wavelength of the dye-sensitized solar cells manufactured according to Example 1 and Comparative Examples 1 and 2 were measured and the results are shown in FIG. 7 below.

Referring to FIG. 7, the dye-sensitized solar cell of Example 1 has a higher scattering effect than the dye-sensitized solar cell of Comparative Example 1, and has a similar scattering effect to that of the dye-sensitized solar cell of Comparative Example 2 (which was not doped with the $NbCl_5$ inorganic binder solution).

As described above, a method of forming a photoelectrode structure according to one or more embodiments of the present invention includes forming a light-scattering layer including a nanowire on a photoanode substrate to induce light-scattering and provide a delivery pathway for the generated photoelectrons, thereby increasing the photocurrent density and efficiency of the dye-sensitized solar cell. Also, an inorganic binder solution is applied to the light-scattering layer to enhance the adhesive force of the light-scattering layer to the photoanode substrate, thereby increasing the durability of the photoelectrode structure.

While the present invention has been illustrated and described with reference to certain exemplary embodiments, it will be understood by those of ordinary skill in the art that various modifications and alterations may be made without departing from the present invention as defined by the appended claims.

**Claims**

1. A method of manufacturing a photoelectrode structure, the method comprising:

    disposing a light-scattering layer comprising a nanowire on a photoanode substrate; and
    applying an inorganic binder solution to the light-scattering layer to fix the light-scattering layer on the photoanode substrate.

2. The method of claim 1, wherein the photoanode substrate comprises:

    a light-transmissible conductive substrate; and
    a light-absorbing layer on the light-transmissible conductive substrate and comprising nanoparticles to which a dye is absorbed.

3. The method of claim 2, wherein the light-scattering layer covers at least a portion of the light-absorbing layer, and at least a portion of the light-scattering layer contacts the light-transmissible conductive substrate.

4. The method of claim 2 or 3, wherein the nanoparticles comprise a material selected from the group consisting of titanium (Ti) oxide, tin (Sn) oxide, niobium (Nb) oxide, zirconium (Zr) oxide, tungsten (W) oxide, vanadium (V) oxide, zinc (Zn) oxide, copper (Cu) oxide, iron (Fe) oxide, lead (Pb) oxide, bismuth (Bi) oxide, cadmium (Cd) oxide, tantalum (Ta) oxide, strontium (Sr) oxide, indium (In) oxide, iridium (Ir) oxide, lanthanum (La) oxide, molybdenum (Mo) oxide, magnesium (Mg) oxide, aluminum (Al) oxide, yttrium (Y) oxide, scandium (Sc) oxide, samarium (Sm) oxide, gallium (Ga) oxide, strontium titanium (SrTi) oxide, potassium tantalum (KTa) oxide, barium titanium (BaTi) oxide, iron titanium (FeTi) oxide, yttrium iron (YFe) oxide, cadmium iron (CdFe) oxide, lead iron (PbFe) oxide, mercury niobium (HgNb) oxide, $ZnS$, $In_2S_3$, $CdS$, $ZrS_2$, $HgS$, $MoS_2$, $HfS_2$, $Fe_2S$, $PbS$, and combinations thereof, the nanoparticles preferably comprising titanium dioxide ($TiO_2$), zinc oxide (ZnO), tin dioxide ($SnO_2$), niobium oxide ($Nb_2O_5$), tungsten trioxide ($WO_3$), or a mixture thereof.

5. The method of anyone of claims 1 to 4, wherein the nanowire comprises a material selected from the group consisting of titanium (Ti) oxide, tin (Sn) oxide, niobium (Nb) oxide, zirconium (Zr) oxide, tungsten (W) oxide, vanadium (V) oxide, zinc (Zn) oxide, copper (Cu) oxide, iron (Fe) oxide, lead (Pb) oxide, bismuth (Bi) oxide, cadmium (Cd) oxide, tantalum (Ta) oxide, strontium (Sr) oxide, indium (In) oxide, iridium (Ir) oxide, lanthanum (La) oxide, molybdenum (Mo) oxide, magnesium (Mg) oxide, aluminum (Al) oxide, yttrium (Y) oxide, scandium (Sc) oxide, samarium (Sm) oxide, gallium (Ga) oxide, strontium titanium (SrTi) oxide, potassium tantalum (KTa) oxide, barium titanium (BaTi) oxide, iron titanium (FeTi) oxide, yttrium iron (YFe) oxide, cadmium iron (CdFe) oxide, lead iron (PbFe) oxide, mercury niobium (HgNb) oxide, $ZnS$, $In_2S_3$, $CdS$, $ZrS_2$, $HgS$, $MoS_2$, $HfS_2$, $Fe_2S$, $PbS$, and combinations thereof, the nanowire preferably comprising titanium dioxide ($TiO_2$), zinc oxide (ZnO) or a mixture thereof.

6. The method of anyone of claims 1 to 5, wherein the light-scattering layer has a structure in which the nanowire is tangled.

7. The method of anyone of claims 1 to 6, wherein disposing the light-scattering layer comprises electrospinning and heat treating a precursor solution on a surface of the photoanode substrate, the precursor solution comprising a nanowire precursor.

8. The method of claim 7, wherein the nanowire precursor comprises a material selected from the group consisting of titanium isopropoxide, titanium ethoxide, titanium chloride, titanium methoxide, and combinations thereof.

9. The method of claim 7 or 8, wherein the electrospinning is performed at a voltage of about 5 to about 10 kV, a speed of about 10 to about 20 $\mu$l/minute, for about 1 to about 30 minutes.

10. The method of anyone of claims 7 to 9, wherein during electrospinning of the precursor solution, the temperature of the photoanode substrate is maintained at about 100 to about 350°C.

11. The method of anyone of claims 7 to 10, wherein the heat treatment is performed at a temperature of about 400 to about 600°C.

12. The method of claim 1, further comprising fixing a dye to the light-scattering layer after either disposing the light-scattering layer or the fixing of the light-scattering layer.

13. The method of anyone of claims 1 to 12, wherein the inorganic binder solution comprises a $TiO_2$ sol, the $TiO_2$ sol preferably comprising $TiO_2$ nanoparticles having a diameter of about 5 to about 50 nm.

14. The method of anyone of claims 1 to 12, wherein the inorganic binder solution comprises a $NbCl_5$-containing solution.

15. The method of anyone of claims 1 to 14, further comprising heat treating the light-scattering layer coated with the inorganic binder solution after the applying the inorganic binder solution.

16. A photoelectrode structure (1) comprising:

   a photoanode substrate (10); and
   a light-scattering layer (20) that comprises a nanowire and is disposed on the photoanode substrate,
   wherein the light-scattering layer is fixed on the photoanode substrate by an inorganic binder.

17. The photoelectrode structure of claim 16, wherein the nanowire comprises at least one selected from the group consisting of titanium (Ti) oxide, tin (Sn) oxide, niobium (Nb) oxide, zirconium (Zr) oxide, tungsten (W) oxide, vanadium (V) oxide, zinc (Zn) oxide, copper (Cu) oxide, iron (Fe) oxide, lead (Pb) oxide, bismuth (Bi) oxide, cadmium (Cd) oxide, tantalum (Ta) oxide, strontium (Sr) oxide, indium (In) oxide, iridium (Ir) oxide, lanthanum (La) oxide, molybdenum (Mo) oxide, magnesium (Mg) oxide, aluminum (Al) oxide, yttrium (Y) oxide, scandium (Sc) oxide, samarium (Sm) oxide, gallium (Ga) oxide, strontium titanium (SrTi) oxide, potassium tantalum (KTa) oxide, barium titanium (BaTi) oxide, iron titanium (FeTi) oxide, yttrium iron (YFe) oxide, cadmium iron (CdFe) oxide, lead iron (PbFe) oxide, mercury niobium (HgNb) oxide, ZnS, In2S3, CdS, ZrS2, HgS, MoS2, HfS2, Fe2S, PbS, and combinations thereof, the nanowire preferably comprising titanium dioxide (Ti02), zinc oxide (ZnO) or a mixture thereof.

18. The photoelectrode structure of claim 16 or 17, wherein the inorganic binder comprises Ti02 nanoparticles.

19. The photoelectrode structure of claim 16 or 17, wherein the inorganic binder comprises Nb205.

20. The photoelectrode structure of anyone of claims 16 to 19, wherein the photoelectrode structure comprises a light-transmissible conductive substrate; and a light-absorbing layer which is disposed on the light-transmissible conductive substrate and comprises nanoparticles to which a dye is adsorbed.

21. The photoelectrode structure of claim 20, wherein the light-scattering layer is disposed such that the light-scattering layer covers at least a portion of the light-absorbing layer and at least a portion of the light-scattering layer contacts the light-transmissible conductive substrate.

22. The photoelectrode structure of anyone of claims 16 to 21, wherein at least a portion of the nanowire present at an interface with the light-absorbing layer is embedded in the light-absorbing layer.

23. The photoelectrode structure of anyone of claims 16 to 22, wherein the light-scattering layer has a nanowire tangled structure.

24. The photoelectrode structure of anyone of claims 16 to 23, wherein the light-scattering layer further comprises a dye which is adsorbed to the nanowire.

25. A dye-sensitive solar cell comprising:

   a first electrode comprising the photoelectrode structure of any one of claims 16-24;
   a second electrode facing the first electrode; and
   an electrolyte disposed between the first electrode and the second electrode.

FIG. 1

FIG. 2

FIG. 3

FIG. 4

FIG. 5

FIG. 6

FIG. 7